(19) Europäisches Patentamt
European Patent Office
Office européen des brevets

(11) **EP 4 773 498 A1**

(12) **EUROPEAN PATENT APPLICATION**
published in accordance with Art. 153(4) EPC

(43) Date of publication:
**08.07.2026 Bulletin 2026/28**

(51) International Patent Classification (IPC):
*H02M 7/48* (2007.01)

(21) Application number: **23950849.2**

(22) Date of filing: **01.09.2023**

(52) Cooperative Patent Classification (CPC):
**G01R 31/64; G01R 19/16576; G01R 31/42;
H02M 1/322; H02M 1/36; H02M 7/487;
H02M 7/53871**

(86) International application number:
**PCT/JP2023/032118**

(87) International publication number:
**WO 2025/046908 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **TMEIC Corporation
Tokyo 104-0031 (JP)**

(72) Inventor: **TSURUMA, Yoshinori
Tokyo 104-0031 (JP)**

(74) Representative: **Winter, Brandl - Partnerschaft
mbB
Alois-Steinecker-Straße 22
85354 Freising (DE)**

(54) **POWER CONVERSION DEVICE AND CONTROL DEVICE**

(57)     There is provided a power conversion apparatus including: an inverter device having a DC input section having a positive electrode terminal and a negative electrode terminal, an inverter circuit that converts power on a basis of a switching operation of a switching element, a DC capacitor that absorbs and smooths a ripple current generated by the switching operation of the inverter circuit between the positive electrode terminal and the negative electrode terminal, a discharge resistor in which charges of the DC capacitor are discharged, and a DC voltage sensor that detects a DC voltage value of the DC capacitor; and a controller having a monitoring unit that monitors the DC voltage value detected by the DC voltage sensor, a timing unit that times an elapsed time period since the inverter device stops, a determination unit that when it is timed by the timing unit that a predetermined time period has elapsed since the inverter device stops, determines that the DC capacitor has an abnormality when the DC voltage value being monitored by the monitoring unit falls below a predetermined threshold value which is a value smaller than a normal value by more than or equal to a predetermined range, and a reporting unit that when it is determined by the determination unit that the DC capacitor has the abnormality, reports the abnormality of the DC capacitor.

FIG.3

DETECTION FLOW

## Description

Technical Field

The present invention relates to a power conversion apparatus and a controller.

Background Art

For example, in a power conversion apparatus that converts power between DC power and AC power, a DC input section is provided with a DC capacitor for absorbing (smoothing) a ripple current. An abnormality such as a drop in capacitance may arise in the DC capacitor due to degradation over time, a failure, or the like, for example. However, it has been difficult to appropriately find an abnormality of the DC capacitor.

Thus, a technique for detecting an abnormality such as a drop in capacitance of a DC capacitor in an inverter on the basis of the magnitude of a resistor current when a predetermined reference time period elapses since the start of energization, and the magnitude of a voltage across capacitor terminals, has been proposed conventionally (for example, see PTL 1).

Citation List

Patent Literature

[PTL 1] JP 2008228370 A

Summary of the Invention

Problems to be Solved by the Invention

In general, when the capacitance of the DC capacitor drops, the voltage of the DC capacitor has a magnitude different from that at a normal time when the DC capacitor is charged when a device is started up and the DC capacitor is discharged when the device stops.

However, the conventional technique fails to find an abnormality of the DC capacitor on the basis of the discharge voltage of the DC capacitor when the device stops although enabling an abnormality of the DC capacitor to be found on the basis of the charge voltage of the DC capacitor when the device is started up.

Therefore, the present disclosure has an object to provide means for monitoring a discharge rate of a DC voltage when a device stops, thereby finding an abnormality of a DC capacitor connected to a DC input side of a power conversion apparatus on the basis of a discharge voltage of the DC voltage when the device stops.

Means for Solving the Problems

A power conversion apparatus according to an aspect comprises: an inverter device including a DC input section having a positive electrode terminal and a negative electrode terminal, an inverter circuit that converts power on a basis of a switching operation of a switching element, a DC capacitor that absorbs and smooths a ripple current generated by the switching operation of the inverter circuit between the positive electrode terminal and the negative electrode terminal, a discharge resistor in which charges of the DC capacitor are discharged, and a DC voltage sensor that detects a DC voltage value of the DC capacitor; and a controller including a monitoring unit that monitors the DC voltage value detected by the DC voltage sensor, a timing unit that times an elapsed time period since the inverter device stops, a determination unit that when it is timed by the timing unit that a predetermined time period has elapsed since the inverter device stops, determines that the DC capacitor has an abnormality when the DC voltage value being monitored by the monitoring unit falls below a predetermined threshold value which is a value smaller than a normal value by more than or equal to a predetermined range, and a reporting unit that when it is determined by the determination unit that the DC capacitor has the abnormality, reports the abnormality of the DC capacitor.

A power conversion apparatus according to another aspect comprises: an inverter device including a DC input section having a positive electrode terminal and a negative electrode terminal, an inverter circuit that converts power on a basis of a switching operation of a switching element, a plurality of DC capacitors that are connected in series via a DC neutral point between the positive electrode terminal and the negative electrode terminal, and absorb and smooth a ripple current generated by the switching operation of the inverter circuit, a discharge resistor in which each of charges of the plurality of DC capacitors is discharged, and a DC voltage sensor that detects each of DC voltage values of the plurality of DC capacitors; and a controller including a monitoring unit that monitors each of the DC voltage values of the plurality of DC capacitors detected by the DC voltage sensor, a timing unit that times an elapsed time period since the inverter device stops, a determination unit that when it is timed by the timing unit that a predetermined time period has elapsed since the inverter device stops, compares the DC voltage values of the plurality of DC capacitors being monitored by the monitoring unit, and when the DC voltage values of the plurality of DC capacitors as compared differ from each other by more than or equal to a predetermined threshold value, determines that any DC capacitor among the plurality of DC capacitors as compared has an abnormality, and a reporting unit that when it is determined by the determination unit that any DC capacitor among the plurality of DC capacitors has the abnormality, reports that any DC capacitor among the plurality of DC capacitors has the abnormality.

A controller according to an aspect is a controller of a power conversion apparatus including an inverter device having a DC input section having a positive electrode terminal and a negative electrode terminal,

an inverter circuit that converts power on a basis of a switching operation of a switching element, a DC capacitor that absorbs and smooths a ripple current generated by the switching operation of the inverter circuit between the positive electrode terminal and the negative electrode terminal, a discharge resistor in which charges of the DC capacitor are discharged, and a DC voltage sensor that detects a DC voltage value of the DC capacitor, the controller comprises: a monitoring unit that monitors the DC voltage value detected by the DC voltage sensor; a timing unit that times an elapsed time period since the inverter device stops; a determination unit that when it is timed by the timing unit that a predetermined time period has elapsed since the inverter device stops, determines that the DC capacitor has an abnormality when the DC voltage value being monitored by the monitoring unit falls below a predetermined threshold value which is a value smaller than a normal value by more than or equal to a predetermined range; and a reporting unit that when it is determined by the determination unit that the DC capacitor has the abnormality, reports the abnormality of the DC capacitor.

Advantageous Effect of the Invention

The present disclosure can provide means for monitoring a discharge rate of a DC voltage when a device stops, thereby finding an abnormality of a DC capacitor connected to a DC input side of a power conversion apparatus on the basis of a discharge voltage of the DC voltage when the device stops.

Brief Description of the Drawings

[Fig. 1]

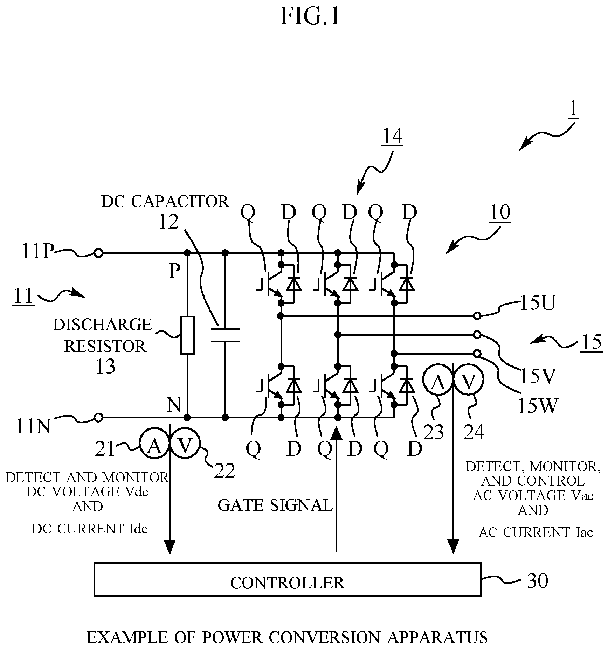

Fig. 1 is a diagram showing a configuration example of a power conversion apparatus according to a first embodiment.
[Fig. 2]

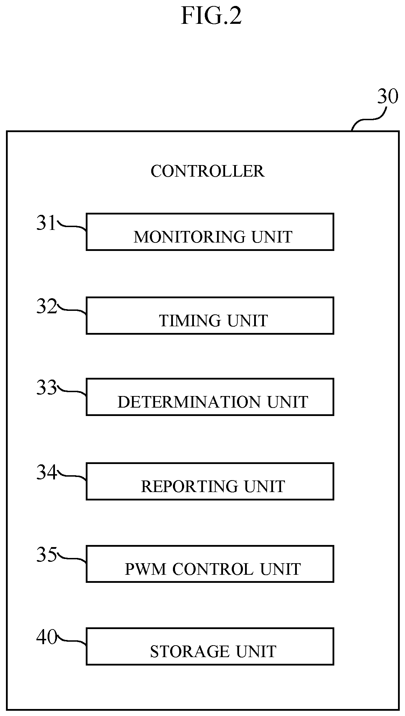

Fig. 2 is a diagram showing a configuration example of a controller in the power conversion apparatus shown in Fig. 1.
[Fig. 3]

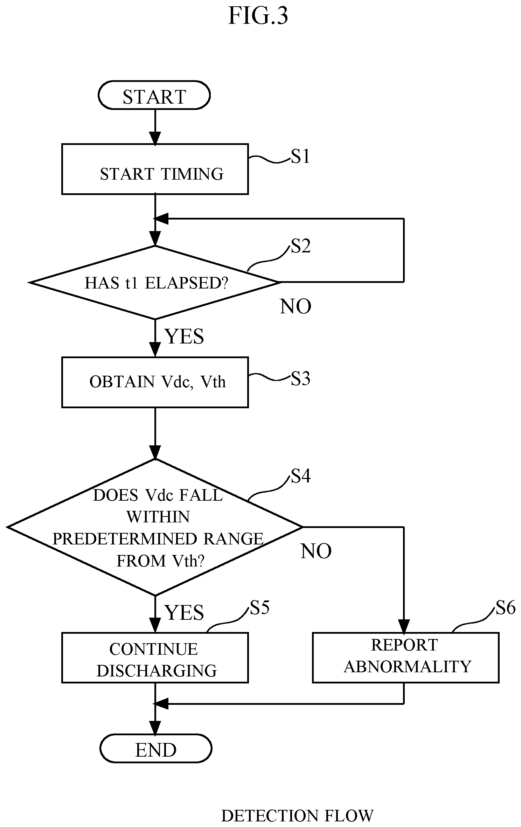

Fig. 3 is a flowchart showing an example of operation of the controller in the power conversion apparatus shown in Fig. 1 and Fig. 2.
[Fig. 4]

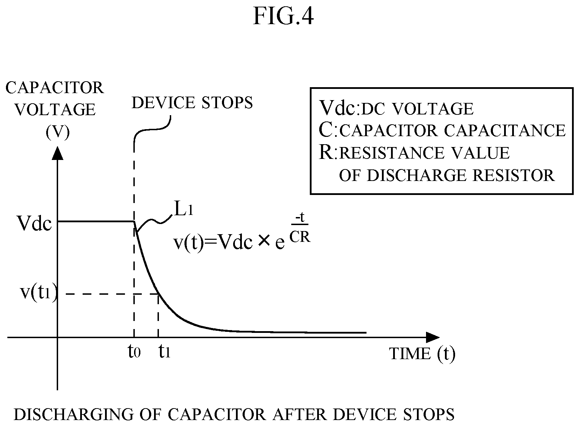

Fig. 4 is a diagram showing an example of a discharge curve when a DC capacitor discharges after an inverter device stops.
[Fig. 5]

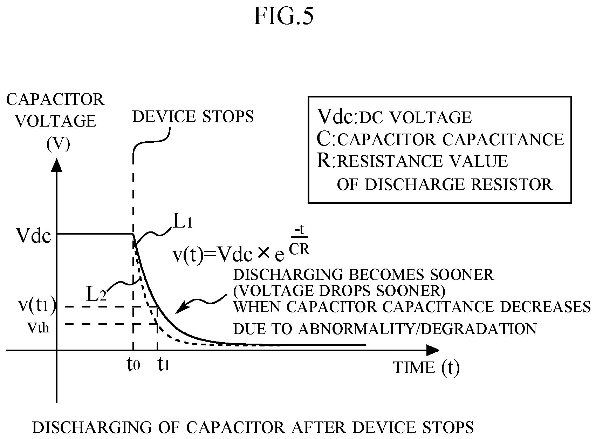

Fig. 5 is a diagram showing an example of the discharge curve of a normal DC capacitor shown in Fig. 4 and a discharge curve as a predetermined threshold value.
[Fig. 6]

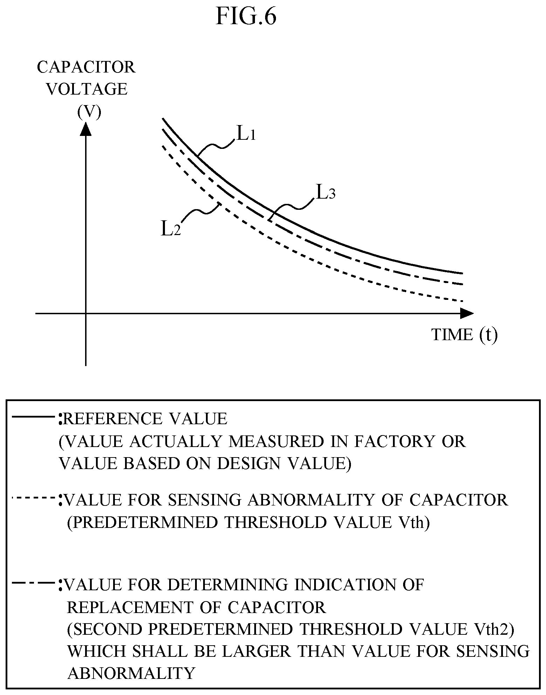

Fig. 6 is a diagram showing an example of a discharge curve of a normal DC capacitor according to a modification of the first embodiment, a discharge curve as a predetermined threshold value, and a discharge curve as a second predetermined threshold value.
[Fig. 7]

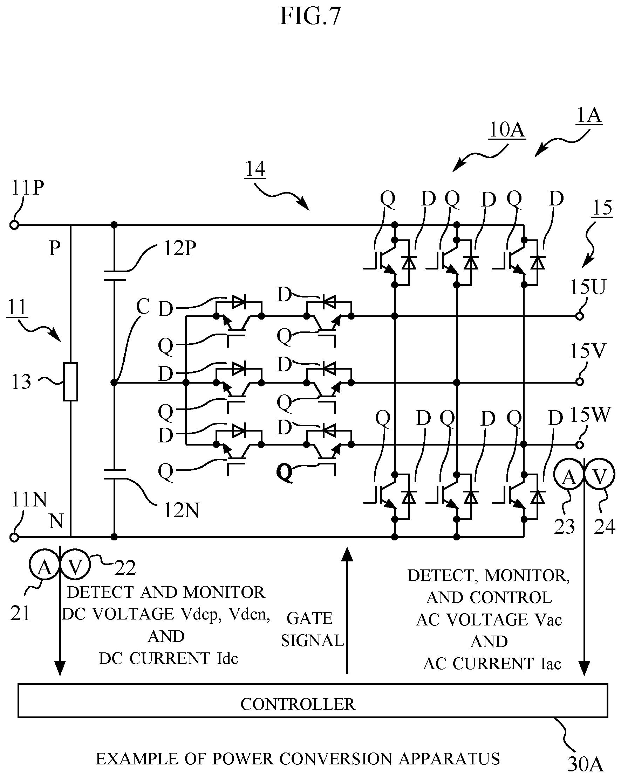

Fig. 7 is a diagram showing a configuration example of a power conversion apparatus according to a second embodiment.
[Fig. 8]

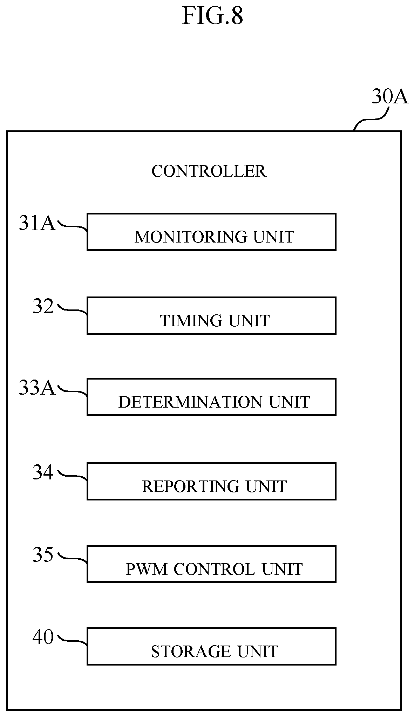

Fig. 8 is a diagram showing a configuration example of a controller in the power conversion apparatus shown in Fig. 7.
[Fig. 9]

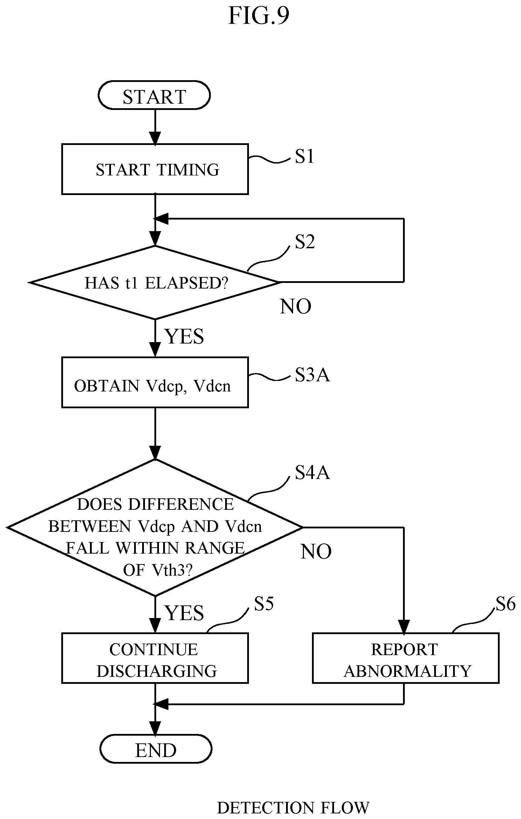

Fig. 9 is a flowchart showing an example of operation of the controller in the power conversion apparatus shown in Fig. 7 and Fig. 8.
[Fig. 10]

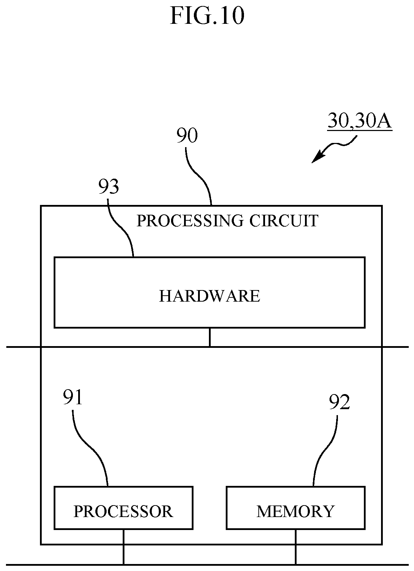

Fig. 10 is a conceptual diagram showing a hardware configuration example of a processing circuit that the controller in the embodiments shown in Fig. 1 to Fig. 9 have. Description of Embodiments

Hereinafter, embodiments of a power conversion apparatus and a controller according to the present disclosure will be described using the drawings.

<CONFIGURATION OF FIRST EMBODIMENT>

Fig. 1 is a diagram showing a configuration example of a power conversion apparatus 1 according to a first embodiment.

As shown in Fig. 1, the power conversion apparatus 1 has an inverter device 10 and a controller 30.

The inverter device 10 has a DC input section 11, a DC capacitor 12, a discharge resistor 13, an inverter circuit 14, and an AC output section 15. The inverter device 10 converts DC power supplied from the DC input section 11 side, for example, into AC power via the inverter circuit 14 and outputs the converted AC power to the AC output section 15 side.

The inverter device 10 is, for example, a DC-AC inverter or the like that converts DC power into AC power. The DC input section 11 is connected to DC power such as a solar panel (solar cell) or a storage battery. The AC output section 15 is connected to a load such as an AC power system or a motor. In the following embodiment, the inverter device 10 will be described taking a DC-AC inverter that converts DC power into AC power as an example. However, the present disclosure is not limited to this, and the inverter device 10 of the present disclosure can be established as long as it has the DC capacitor 12, the discharge resistor 13, and means for sensing a DC voltage Vdc of the DC capacitor 12 which will be described later.

In other words, the inverter device 10 may be, for example, a converter or the like that converts alternating current into direct current as long as it has the DC capacitor 12, the discharge resistor 13, and the means for sensing the DC voltage Vdc of the DC capacitor 12 which will be described later. Alternatively, the inverter device 10 may be, for example, a static var compensator or the like that generates a DC voltage by operation of the inverter circuit 14 or the like and exchanges reactive power between the DC capacitor and a system while controlling the DC voltage to be constant, thereby accomplishing voltage stabilization or the like. Alternatively, the inverter device 10 may be a DC-DC conversion device or the like such as a DC chopper. Note that hereinafter, in the present specification and the like, the inverter device 10 will also be simply referred to as the "device" or the "device 10."

The DC input section 11 has a positive electrode terminal 11P and a negative electrode terminal 11N. The positive electrode terminal 11P and the negative electrode terminal 11N of the DC input section 11 are connected to a DC power supply not shown, such as a solar cell, at one end side on the left in Fig. 1 and are connected to the inverter device 10 at the other end side on the right in Fig. 1, for example. Note that in a case in which the inverter device 10 is a static var compensator or the like, for example, nothing may be connected to the one end sides of the positive electrode terminal 11P and the negative electrode terminal 11N of the DC input section 11.

The DC capacitor 12 is arranged between the positive electrode terminal 11P and the negative electrode terminal 11N, for example, and absorbs and smooths a ripple current generated by a switching operation of a switching element of the inverter circuit 14. The DC capacitor 12 is almost always included in a voltage-type inverter, is charged when the inverter device 10 is started up (when energization is started), and is discharged when the inverter device 10 stops.

When the DC capacitor 12 drops in capacitance due to degradation over time, occurrence of an abnormality (failure), or the like, the voltage has a magnitude different from that at the normal time, during charging when the inverter device 10 is started up and during discharging when the inverter device 10 stops. In addition, in this case, the DC capacitor 12 is brought into a state in which a charge curve indicating a charge rate during charging and a discharge curve indicating a discharge rate during discharging have inclinations and magnitudes different from those at the normal time.

The discharge resistor 13 is a resistor arranged between the positive electrode terminal 11P and the negative electrode terminal 11N, for example, and provided for discharging charges of the DC capacitor 12 after the inverter device 10 stops. The discharge resistor 13 may be either always connected or loaded and connected after the inverter device 10 stops. The discharge resistor 13 may be always connected in the inverter device 10 having the DC capacitor 12 of an intermediate or small capacitance, and may be loaded and connected by a switch not shown or the like after the inverter device 10 stops in the inverter device 10 having the DC capacitor 12 of a large capacitance, for example.

The inverter circuit 14 is structured by a plurality of semiconductor switching elements Q such as IGBTs (Insulated Gate Bipolar Transistors) and a plurality of freewheeling diodes D, for example. Note that the semiconductor switching elements Q are not limited to the IGBTs and may be MOSFETs (metal-oxide-semiconductor field-effect transistors) or the like. The inverter circuit 14 has its one end side, which is an input side, connected to DC power or the like not shown via the DC input section 11 and the other end side, which is an output side, connected to an AC power system or the like not shown via the AC output section, for example.

Operation of the inverter circuit 14 is controlled by a pulse width modulation (PWM) signal which is a gate drive signal (gate signal) for the semiconductor switching elements Q generated by the controller 30. The inverter circuit 14 obtains DC power supplied from the DC input section 11, converts the obtained DC power into AC power in accordance with control by the PWM signal (gate signal), and outputs the converted AC power through the AC output section 15, for example.

The inverter circuit 14 has a circuit in which three legs (a U-phase leg, a V-phase leg, and a W-phase leg) are connected in parallel, for example. Each of the legs is configured by connecting two arms in series, each arm having the semiconductor switching element Q and the freewheeling diode D connected in antiparallel, for example. The respective legs are connected in parallel between the positive electrode terminal 11P and the negative electrode terminal 11N, for example, and intermediate points of the respective legs are connected respectively to a U-phase terminal 15U, a V-phase terminal 15V, and a W-phase terminal 15W of the AC output section 15 which will be described later. Note that the inverter circuit 14 is not limited to a three-phase inverter and may be a single-phase or another inverter.

The AC output section 15 has the U-phase terminal 15U, the V-phase terminal 15V, and the W-phase terminal 15W. The AC output section 15 is connected to the inverter device 10 at one end side on the left in Fig. 1 and connected to a power system, a load, or the like not shown at the other end side on the right in Fig. 1. The AC output section 15 is, for example, a three-phase AC circuit of a three-phase three-wire type that supplies, using three electric wires/cables/conductors, three-phase AC power in which single-phase alternating currents in three systems shifted from one another in phase of current or voltage are combined. Note that the AC output section 15 is not limited to the three-phase AC circuit and may be a single-phase AC circuit or another AC circuit. The AC output section 15 outputs AC power converted by the inverter circuit 14 to the side of the power system, the load, or the like not shown.

In addition, the inverter device 10 has a DC current sensor 21, a DC voltage sensor 22, an AC current sensor 23, and an AC voltage sensor 24.

The DC current sensor 21 is, for example, a publicly-known DC ammeter, DC current sensor, or the like and detects the value of a DC current Idc flowing in the positive electrode terminal 11P and the negative electrode terminal 11N of the DC input section 11. Note that the position at which the DC current sensor 21 is arranged is not limited to the position shown in Fig. 1 and may be any position at which the value of the DC current Idc can be detected. Hereinafter, in the present specification and the like, the value of the DC current Idc will also be simply referred to as the "DC current Idc." The DC current Idc detected by the DC current sensor 21 is monitored by the controller 30.

The DC voltage sensor 22 is, for example, a publicly-known DC voltmeter, DC voltage sensor, or the like and detects the value of the DC voltage Vdc of the DC capacitor 12 of the DC input section 11. Note that the position at which the DC voltage sensor 22 is arranged is not limited to the position shown in Fig. 1 and may be any position at which the value of the DC voltage Vdc of the DC capacitor 12 can be detected. Hereinafter, in the present specification and the like, the value of the DC voltage Vdc will also be simply referred to as the "DC voltage Vdc." The DC voltage Vdc detected by the DC voltage sensor 22 is monitored by the controller 30.

The AC current sensor 23 is, for example, a publicly-known AC ammeter, AC current sensor, or the like and detects the value of an AC current Iac of the AC output section 15 which is an output current of the inverter circuit 14. Note that the position at which the AC current sensor 23 is arranged is not limited to the position shown in Fig. 1 and may be any position at which the value of the AC current Iac can be detected. Hereinafter, in the present specification and the like, the value of the AC current Iac will also be simply referred to as the "AC current Iac." The AC current Iac detected by the AC current sensor 23 is monitored and controlled by the controller 30.

The AC voltage sensor 24 is, for example, a publicly-known AC voltmeter, AC voltage sensor, or the like and detects the value of an AC voltage Vac of the AC output section 15 which is an output voltage of the inverter circuit 14. Note that the position at which the AC voltage sensor 24 is arranged is not limited to the position shown in Fig. 1 and may be any position at which the value of the AC voltage Vac of the AC voltage sensor 24 can be detected. Hereinafter, in the present specification and the like, the value of the AC voltage Vac will also be simply referred to as the "AC voltage Vac." The AC voltage Vac detected by the AC voltage sensor 24 is monitored and controlled by the controller 30.

The controller 30 is provided inside or outside the power conversion apparatus 1, for example, and is electrically connected by wire or wirelessly to respective components of the inverter device 10 including the inverter circuit 14 although wiring lines and the like are omitted in the diagram. Note that the controller 30 may be implemented as a function of an inverter control circuit not shown.

The controller 30 has a processor 91 (see Fig. 10) which will be described later, such as a CPU (Central Processing Unit) that operates by execution of a program, for example. The controller 30 has a storage unit 40 (see Fig. 2) and a memory 92 (see Fig. 10) which will be described later, and the like and executes a predetermined program stored in the storage unit 40 or the memory 92, for example, to operate the processor 91, thereby exercising overall control over operation of the inverter device 10. Note that the controller 30 may control operation of the inverter device 10 in accordance with an instruction received from a host device not shown, an instruction received from an operator not shown via an operation unit not shown, or the like.

The controller 30 detects a failure, an abnormality, a capacitance drop, or the like of the DC capacitor 12 on the basis of the DC voltage Vdc detected by the DC voltage sensor 22. When an abnormality or the like of the DC capacitor 12 is detected, the controller 30 reports that an abnormality or the like of the DC capacitor 12 has been detected.

Fig. 2 is a diagram showing a configuration example of the controller 30 in the power conversion apparatus 1 shown in Fig. 1.

The controller 30 has the storage unit 40 and executes a predetermined program stored in the storage unit 40 or the memory 92 (see Fig. 10) which will be described later, for example, thereby functioning as the following respective units. In other words, the controller 30 executes the predetermined program, thereby functioning as a monitoring unit 31, a timing unit 32, a determination unit 33, a reporting unit 34, and a PWM control unit 35. Note that the above-described respective functions may be implemented by a program executed by the processor 91 (see Fig. 10) that the controller 30 has, or may be implemented by hardware 93 (see Fig. 10). The above-described respective units execute the predetermined program to perform the following processing.

The monitoring unit 31 is connected to the DC voltage sensor 22 and always obtains and monitors information on the DC voltage Vdc of the DC capacitor 12 detected by the DC voltage sensor 22. Note that the monitoring unit 31 may obtain and monitor the information on the DC voltage Vdc of the DC capacitor 12 at a predetermined time interval, for example, or may obtain and monitor the information on the DC voltage Vdc of the DC capacitor 12 in accordance with an instruction received from an operator or the like via a host device not shown or an operation unit not shown. In addition, the monitoring unit 31 may obtain and monitor the information on the DC voltage Vdc of the DC capacitor 12 when the inverter device 10 stops. Note that the monitoring unit 31 may also be connected to the DC current sensor 21, the AC current sensor 23, and the AC voltage sensor 24 to obtain and monitor information on the DC current Idc, the AC current Iac, and the AC voltage Vac detected by them.

When the inverter device 10 stops, the timing unit 32 times an elapsed time period since the inverter device 10 stops. The elapsed time period timed by the timing unit 32 is obtained by the determination unit 33. Note that the timing unit 32 may time whether or not a predetermined time period $t_1$ has elapsed since the inverter device 10 stops. In this case, when the predetermined time period $t_1$ elapses since the inverter device 10 stops, the timing unit 32 outputs information on the fact that the predetermined time period $t_1$ has elapsed since the inverter device 10 stops to the determination unit 33.

When it is timed by the timing unit 32 that the predetermined time period $t_1$ has elapsed since the inverter device 10 stops, the determination unit 33 obtains information on the DC voltage Vdc monitored by the monitoring unit 31. When it is timed by the timing unit 32 that the predetermined time period $t_1$ has elapsed since the inverter device 10 stops, the determination unit 33 compares the DC voltage Vdc monitored by the monitoring unit 31 and a predetermined threshold value $V_{th}$.

Note that the determination unit 33 may always obtain the information on the DC voltage Vdc monitored by the monitoring unit 31. Then, the determination unit 33 may always continue comparing the DC voltage Vdc monitored by the monitoring unit 31 and the predetermined threshold value $V_{th}$.

When the DC voltage Vdc monitored by the monitoring unit 31 falls below the predetermined threshold value $V_{th}$, the determination unit 33 determines that the DC capacitor 12 has an abnormality. This is because, when an abnormality occurs in the DC capacitor 12, the capacitance of the DC capacitor 12 drops. Then, when determining that the DC capacitor 12 has an abnormality, the determination unit 33 outputs information on the determination that the DC capacitor 12 has an abnormality to the reporting unit 34. Note that when determining that the DC capacitor 12 has an abnormality, the determination unit 33 may output the information on the determination that the DC capacitor 12 has an abnormality to an external device such as a host device not shown.

Note that the predetermined threshold value $V_{th}$ may vary depending on an operating situation of the inverter device 10, for example, and may be set in advance by an experiment, a simulation, or the like and stored in the storage unit 40. Alternatively, the predetermined threshold value $V_{th}$ may be set in accordance with an instruction received from a host device not shown, an instruction received from an operator not shown via an operation unit not shown, or the like, for example.

Herein, the predetermined threshold value $V_{th}$ is a value (voltage value) smaller than the normal DC voltage Vdc (normal value) detected by the normal DC capacitor 12 when the predetermined time period $t_1$ elapses since the inverter device 10 stops. The predetermined threshold value $V_{th}$ may have (thereabove and therebelow or therebelow) a bandwidth or margin in a predetermined range (predetermined voltage value). In other words, the determination unit 33 may determine that the DC capacitor 12 has an abnormality when the DC voltage Vdc falls below the predetermined threshold value $V_{th}$ by more than or equal to the predetermined range, rather than determining that the DC capacitor 12 has an abnormality as soon as the DC voltage Vdc falls below the predetermined threshold value $V_{th}$. Note that the bandwidth or margin in the predetermined range may be varied depending on an estimated lifetime of the DC capacitor 12 or the like.

This prevents an abnormality of the DC capacitor 12 from being detected by the determination unit 33 with temporary or accidental variations in the DC voltage Vdc or the like, for example. Thus, erroneous detection of an abnormality by the determination unit 33 is reduced as compared with a case in which the predetermined threshold value $V_{th}$ does not have the bandwidth or margin in the predetermined range, and the determination unit 33 can detect an abnormality of the DC capacitor 12 more accurately.

Note that as described above, the determination unit 33 may determine that the DC capacitor 12 has an abnormality when the DC voltage Vdc falls below the predetermined threshold value $V_{th}$ by more than or equal to the predetermined range (predetermined voltage value). However, the present disclosure is not limited to this, and the determination unit 33 may determine that the DC capacitor 12 has an abnormality when the DC voltage Vdc falls below the predetermined threshold value $V_{th}$ for more than or equal to a predetermined time period. Alternatively, the determination unit 33 may determine that the DC capacitor 12 has an abnormality when the DC voltage Vdc falls below the predetermined threshold value $V_{th}$ by more than or equal to a predetermined number of times.

Moreover, the determination unit 33 may determine that the DC capacitor 12 has an abnormality by a combination of some of or all of the bandwidth or margin in the predetermined range provided for the predetermined threshold value $V_{th}$, the time period, and the number of times. For example, the determination unit 33 may determine that the DC capacitor 12 has an abnormality when the DC voltage Vdc falls below the predetermined threshold value $V_{th}$ for more than or equal to the predetermined time period and by more than or equal to the predetermined number of times.

In addition, the determination unit 33 may determine that the DC capacitor 12 has an abnormality when the DC voltage Vdc falls below the predetermined threshold value $V_{th}$ by more than or equal to the predetermined range (predetermined voltage value) for more than or equal to the predetermined time period, for example. In addition, the determination unit 33 may determine that the DC capacitor 12 has an abnormality when the DC voltage Vdc falls below the predetermined threshold value $V_{th}$ by more than or equal to the predetermined range (predetermined voltage value) by more than or equal to the predetermined number of times, for example. Alternatively, the determination unit 33 may determine that the DC capacitor 12 has an abnormality when the DC voltage Vdc falls below the predetermined threshold value $V_{th}$ by more than or equal to the predetermined range (predetermined voltage value) for more than or equal to the predetermined time period and by more than or equal to the predetermined number of times, for example.

Accordingly, erroneous detection of an abnormality by the determination unit 33 is reduced as compared with a case in which the bandwidth or margin in the predetermined range provided for the predetermined threshold value $V_{th}$, the time period, and the number of times are not combined, and the determination unit 33 can detect an abnormality of the DC capacitor 12 more accurately.

When obtaining information on the determination that the DC capacitor 12 has an abnormality from the determination unit 33, the reporting unit 34 reports the abnormality of the DC capacitor 12. The reporting unit 34 reports the abnormality of the DC capacitor 12 by, for example, outputting failure information to a host device not shown or the like or outputting display, sound, or the like, such as a warning or an alarm, to a display unit, an operation unit, or the like not shown of the power conversion apparatus 1. Note that the reporting unit 34 may stop discharging from the DC capacitor 12. Note that an external device such as a host device not shown may include the function of the reporting unit 34.

The PWM control unit 35 performs PWM control on the basis of a predetermined output voltage command signal and a predetermined triangular wave-shaped carrier signal, for example, and generates a gate signal for turning on/off the semiconductor switching elements Q of the inverter circuit 14. The PWM control unit 35 outputs the generated gate signal to the inverter circuit 14 of the inverter device 10 to control operation of the inverter circuit 14. When the inverter device 10 stops, and output of the gate signal is stopped, the PWM control unit 35 may output information on the fact that the inverter device 10 has stopped to the timing unit.

The storage unit 40 is, for example, a volatile or nonvolatile storage medium such as HDD (Hard Disk Drive), SSD (Solid State Drive), DRAM (Dynamic Random Access Memory), or another semiconductor memory. The storage unit 40 stores a program necessary for operation of each unit of the controller 30, for example, and various types of information are written to or read out from the storage unit 40 by each unit of the controller 30. The storage unit 40 stores information on values of the DC current Idc, the DC voltage Vdc, the AC current Iac, the AC voltage Vac, and the like monitored by the monitoring unit 31, for example. The storage unit 40 also stores information on the predetermined time period $t_1$, the predetermined threshold value $V_{th}$, and the like as well as various arithmetic expressions, various threshold values, and the like for use in the determination to be made by the determination unit 33 and the like, for example.

The storage unit 40 is connected to each unit of the controller 30 via a bus or the like not shown, for example, in such a manner that various types of information can be input/output to/from each unit of the controller 30. Note that the storage unit 40 may be provided outside the controller 30 and connected to the controller 30 by wire or wirelessly, and may be an external storage medium or the like such as a memory card or DVD (Digital Versatile Disc) or may be an online storage or the like. In addition, the storage unit 40 may be common to the memory 92 (see Fig. 10) which will be described later.

<OPERATION OF FIRST EMBODIMENT>

Fig. 3 is a flowchart showing an example of operation of the controller 30 in the power conversion apparatus 1 shown in Fig. 1 and Fig. 2. The flowchart shown in Fig. 3 is started when the inverter device 10 stops.

In step S1, the timing unit 32 of the controller 30 obtains information on the fact that the inverter device 10 has stopped and starts timing an elapsed time period since the inverter device 10 stops.

In step S2, the determination unit 33 of the controller 30 obtains the time period timed by the timing unit 32 from the timing unit 32 and determines whether or not it is timed by the timing unit 32 that the predetermined time period $t_1$ has elapsed since the inverter device 10 stops. When determining that it is timed by the timing unit 32 that the predetermined time period $t_1$ has elapsed since the inverter device 10 stops (Yes side), the determination unit 33 causes the process to transition to step S3. On the other hand, when determining that it is not timed by the timing unit 32 that the predetermined time period $t_1$ has elapsed since the inverter device 10 stops (No side), the determination unit 33 repeats the processing in step S2 until it is determined that it is timed that the predetermined time period $t_1$ has elapsed.

In step S3, the determination unit 33 obtains from the monitoring unit 31 the information on the DC voltage Vdc of the DC capacitor 12 at the point of time when the predetermined time period $t_1$ elapses. The determination unit 33 also obtains from the storage unit 40 information on the predetermined threshold value $V_{th}$ at the point of time when the predetermined time period $t_1$ elapses.

In step S4, the determination unit 33 determines whether or not the DC voltage Vdc falls within a predetermined range from the predetermined threshold value $V_{th}$ at the point of time when the predetermined time period $t_1$ elapses.

Then, when determining that the DC voltage Vdc falls within the predetermined range from the predetermined threshold value $V_{th}$ at the point of time when the predetermined time period $t_1$ elapses (Yes side), the determination unit 33 causes the process to transition to step S5.

On the other hand, when determining that the DC voltage Vdc does not fall within the predetermined range from the predetermined threshold value $V_{th}$ at the point of time when the predetermined time period $t_1$ elapses (No side), the determination unit 33 causes the process to transition to step S6. In other words, when determining that the DC voltage Vdc falls below the predetermined threshold value $V_{th}$ by more than or equal to the predetermined range (No side) when it is timed by the timing unit 32 that the predetermined time period $t_1$ has elapsed since the inverter device 10 stops, the determination unit 33 causes the process to transition to step S6. Herein, the predetermined threshold value $V_{th}$ may be set on the basis of a discharge curve.

Fig. 4 is a diagram showing an example of a discharge curve when the DC capacitor 12 discharges after the inverter device 10 stops. In other words, Fig. 4 is a diagram showing a discharge curve showing a transition of the DC voltage value when the DC capacitor 12 discharges after the inverter device 10 stops.

In Fig. 4, the vertical axis is the voltage value (V), and the horizontal axis is the time (t). In Fig. 4, the DC voltage Vdc indicates the value of the DC voltage when the inverter device 10 works (stops). In other words, in Fig. 4, the value of the DC voltage from when the inverter device 10 works to when the inverter device 10 stops (time $t_0$) shall be kept at the DC voltage Vdc. When the inverter device 10 is stopped at the time $t_0$, charges of the DC capacitor 12 are discharged to the discharge resistor 13. Fig. 4 shows a discharge curve (v(t)) showing a transition of the DC voltage value when the DC capacitor 12 discharges after the inverter device 10 stops at the time $t_0$. The discharge curve (v(t)) is gained by Expression (1) below.
[Math. 1]

$$v(t) = Vdc \times e^{\frac{-t}{CR}} \qquad \cdots \ (1)$$

In Expression (1), C indicates a design value of the capacitance of the DC capacitor 12, R indicates a design value of the resistance value of the discharge resistor 13, Vdc indicates a DC voltage value of the DC capacitor 12 when the inverter device 10 stops, and t indicates an elapsed time period since the inverter device 10 stops.

Expression (1) represents a discharge curve (v(t)) indicating a way in which the DC voltage value attenuates naturally when the DC capacitor 12 discharges after the inverter device 10 stops. Assuming that $t_0$ is the time at which the inverter device 10 stops (= 0) and $t_1$ is a time at which a predetermined time period elapses since the inverter device 10 stops, the DC voltage value of the DC capacitor 12 at the time ($t_1$) at which the predetermined time period elapses since the time ($t_0$) at which the inverter device 10 stops is v($t_1$).

Note that the design value (C) of the capacitance of the DC capacitor 12 is a value on the order of uF or mF, for example, in many cases. In addition, the design value (R) of the resistance value of the discharge resistor 13 is a value on the order of kΩ, for example, in many cases. Note that since the inverter device 10 of a large capacitance is hardly provided with only a single DC capacitor 12, the design value (C) of the capacitance of the DC capacitor 12 is a combined value (combined capacitance) of the DC capacitors 12 connected in parallel, if any.

Fig. 5 is a diagram showing an example of the discharge curve of the normal DC capacitor 12 shown in Fig. 4 and a discharge curve as the predetermined threshold value $V_{th}$.

In Fig. 5, what are indicated by the vertical axis, the horizontal axis, and the respective reference characters are similar to those in Fig. 4. In other words, in Fig. 5, the DC voltage Vdc also indicates the value of the DC voltage when the inverter device 10 works (stops). In Fig. 5, a solid line $L_1$ is identical to the discharge curve shown in Fig. 4 and indicates the discharge curve of the normal DC capacitor 12. On the other hand, a broken line $L_2$ indicates the discharge curve as the predetermined threshold value $V_{th}$.

As shown in Fig. 5, when the capacitor capacitance decreases due to occurrence of an abnormality, degradation, or the like, the DC capacitor 12 is discharged sooner for the identical discharge resistor 13 because of fewer charges, and the voltage drops sooner. For example, when an abnormality such as disconnection occurs in one of a plurality of the DC capacitors 12 connected in parallel that form the combined capacitance, the DC capacitors 12 are discharged sooner for the identical discharge resistor 13 since charges are fewer by one capacitor, and the voltage drops sooner.

Thus, the discharge curve of the DC capacitor 12 reduced in capacitor capacitance is smaller in voltage value than the discharge curve of the normal DC capacitor 12 and thus becomes the lower line. Thus, as shown in Fig. 5, the broken line $L_2$ indicating the discharge curve as the predetermined threshold value $V_{th}$ is the line below the solid line $L_1$ indicating the discharge curve of the normal DC capacitor 12.

Note that the broken line $L_2$ indicating the discharge curve as the predetermined threshold value $V_{th}$ may have a bandwidth or margin (width) in the predetermined range (predetermined voltage value) as described above. Thus, when it is timed that the predetermined time period $t_1$ has elapsed, the determination unit 33 may determine that the DC capacitor 12 has an abnormality when the value of the DC voltage monitored by the monitoring unit 31 falls below the predetermined threshold value $V_{th}$ by more than or equal to the predetermined range.

Note that the predetermined time period $t_1$ may be timed by a plurality of times rather than once, and may have a predetermined length of time. In addition, whether or not the DC voltage value falls below the predetermined threshold value $V_{th}$ may be determined at a plurality of sample points rather than being determined at a single sample point, or may be determined for the entire discharge curve or a predetermined portion of the discharge curve.

Herein, the predetermined threshold value $V_{th}$ may be gained (may be set) on the basis of a discharge curve based on actual measurement values of a transition of the DC voltage value after the inverter device 10 stops during the factory acceptance test for the power conversion apparatus 1. For example, the broken line $L_2$ indicating the predetermined threshold value $V_{th}$ may be a value (discharge curve) gained from a discharge curve based on actual measurement values during the factory acceptance test for the power conversion apparatus 1 on the basis of an experiment, a simulation, or the like and stored in the storage unit 40. Note that the predetermined threshold value ($V_{th} = L_2$) may be gained on the basis of a time constant ($\tau$) based on actual measurement values of the capacitance (C) of the DC capacitor 12 and the resistance value (R) of the discharge resistor during the factory acceptance test. Note that the predetermined threshold value ($V_{th} = L_2$) gained on the basis of the discharge curve or the time constant ($\tau$) based on actual measurement values during the above-described factory acceptance test may be gained in advance and stored in the storage unit 40 in advance.

In this case, when it is timed by the timing unit 32 that the predetermined time period ($t_1$) has elapsed since the time ($t_0$) at which the inverter device 10 stops, the determination unit 33 compares an actual measurement value of the value of the DC voltage being monitored by the monitoring unit and the above-described predetermined threshold value ($V_{th} = L_2$) as gained.

Then, the determination unit 33 determines that the DC capacitor 12 has an abnormality when the actual measurement value of the value of the DC voltage being monitored by the monitoring unit falls below the predetermined threshold value ($V_{th} = L_2$) set on the basis of actual measurement values during the factory acceptance test for the power conversion apparatus 1 by more than or equal to the predetermined range.

Since the predetermined threshold value $V_{th}$ is gained on the basis of actual measurement values during the factory acceptance test for the power conversion apparatus 1 as described above, the predetermined threshold value $V_{th}$ in conformity to an actual apparatus can be set, and an abnormality of the DC capacitor 12 can be found more accurately than in a case not in conformity to an actual apparatus.

In addition, the predetermined threshold value $V_{th}$ may be gained (may be set) on the basis of the value calculated by Expression (1) above on the basis of the design value (C) of the capacitance of the DC capacitor and the design value (R) of the resistance value of the discharge resistor. For example, the broken line $L_2$ indicating the predetermined threshold value $V_{th}$ may be a value gained on the basis of an experiment, a simulation, or the like from the discharge curve (v(t)) based on the value calculated by Expression (1) above. Note that, for example, the predetermined threshold value $V_{th}$ may be a value gained on the basis of an experiment, a simulation, or the like from a value gained by substituting a timing (the predetermined time period ($t_1$)) at which a diagnosis set in advance is performed into Expression (1) above.

In this case, when it is timed by the timing unit 32 that the predetermined time period ($t_1$) has elapsed since the time ($t_0$) at which the inverter device 10 stops, the determination unit 33 gains a voltage value (v($t_1$)) when the predetermined time period ($t_1$) is substituted into Expression (1) above. Note that the voltage value (v($t_1$)) when the predetermined time period ($t_1$) is substituted into Expression (1) above may be gained in advance and stored in the storage unit 40 in advance.

Then, when it is timed by the timing unit 32 that the predetermined time period ($t_1$) has elapsed since the time ($t_0$) at which the inverter device 10 stops, the determination unit 33 compares an actual measurement value of the value of the DC voltage being monitored by the monitoring unit 31 and the gained voltage value (v($t_1$)). Then, when the actual measurement value of the value of the DC voltage being monitored by the monitoring unit 31 falls below the gained voltage value (v($t_1$)) by more than or equal to the predetermined range, the determination unit 33 determines that the DC capacitor 12 has an abnormality.

Since the predetermined threshold value $V_{th}$ is gained on the basis of the design value (C) of the capacitance of the DC capacitor and the design value (R) of the resistance value of the discharge resistor as described above, an abnormality of the DC capacitor 12 can be found accurately on the basis of the design values.

Referring back to Fig. 3, since the reporting unit 34 does not obtain information on the determination that the DC capacitor 12 has an abnormality from the determination unit 33 in step S5, the controller 30 causes discharging of the DC capacitor 12 to continue and terminates the process of the flowchart in Fig. 3.

In step S6, the reporting unit 34 obtains information on the determination that the DC capacitor 12 has an abnormality from the determination unit 33 and reports the abnormality of the DC capacitor 12. The controller 30 then terminates the process of the flowchart in Fig. 3.

<OPERATIONAL EFFECTS OF FIRST EMBODIMENT>

In the above first embodiment shown in Fig. 1 to Fig. 5, when the predetermined time period $t_1$ elapses since the inverter device 10 stops, it is determined that the DC capacitor 12 has an abnormality when the DC voltage value Vdc falls below the predetermined threshold value $V_{th}$ by more than or equal to the predetermined range. Accordingly, according to the present embodiment, an abnormality of the DC capacitor 12 can be found on the basis of the discharge voltage of the DC voltage Vdc when the inverter device 10 stops by monitoring a discharge rate of the DC voltage Vdc when the inverter device 10 stops.

In addition, according to the first embodiment shown in Fig. 1 to Fig. 5, the predetermined threshold value $V_{th}$ may have a bandwidth or margin in the predetermined range (predetermined voltage value). Accordingly, according to the present embodiment, erroneous detection of an abnormality by the determination unit 33 is reduced as compared with the case in which the predetermined threshold value $V_{th}$ does not have the bandwidth or margin in the predetermined range, and the determination unit 33 can detect an abnormality of the DC capacitor 12 more accurately.

In addition, according to the first embodiment shown in Fig. 1 to Fig. 5, the predetermined threshold value $V_{th}$ may be gained on the basis of the discharge curve based on actual measurement values of a transition of the DC voltage value after the inverter device 10 stops during the factory acceptance test for the power conversion apparatus 1. Accordingly, according to the present embodiment, the predetermined threshold value $V_{th}$ in conformity to an actual apparatus can be set, and an abnormality of the DC capacitor 12 can be found more accurately than in the case not in conformity to an actual apparatus.

In addition, according to the first embodiment shown in Fig. 1 to Fig. 5, the predetermined threshold value $V_{th}$ may be gained on the basis of the value calculated by Expression (1) above on the basis of the design value (C) of the capacitance of the DC capacitor and the design value (R) of the resistance value of the discharge resistor. Accordingly, according to the present embodiment, an abnormality of the DC capacitor 12 can be found accurately on the basis of the design values.

<MODIFICATION OF FIRST EMBODIMENT>

Fig. 6 is a diagram showing an example of a discharge curve of the normal DC capacitor 12, a discharge curve as the predetermined threshold value $V_{th}$, and a discharge curve as a second predetermined threshold value $V_{th2}$ according to a modification of the first embodiment.

In the modification of the first embodiment, components which are identical or similar to those of the first embodiment shown in Fig. 1 to Fig. 5 are denoted by the same reference characters, and detailed description will be omitted or simplified. In the modification of the first embodiment, the configuration and operation of the power conversion apparatus 1 are identical or similar to those of the first embodiment shown in Fig. 1 to Fig. 5, and illustration thereof is thus omitted. In the modification of the first embodiment, the second predetermined threshold value $V_{th2}$ is used in addition to the predetermined threshold value $V_{th}$ in the first embodiment shown in Fig. 1 to Fig. 5.

In Fig. 6, what are indicated by the vertical axis, the horizontal axis, and the respective reference characters are similar to those in Fig. 4 and Fig. 5. In other words, in Fig. 6, the solid line $L_1$ is similar to the solid line $L_1$ of the discharge curve shown in Fig. 5 and indicates an example of a discharge curve of the normal DC capacitor 12. For example, the solid line $L_1$ indicates an example of a discharge curve as, for example, a reference value based on actual measurement values during the factory acceptance test for the power conversion apparatus 1 or a reference value based on a design value of the capacitance of the DC capacitor and a design value of the resistance value of the discharge resistor.

In addition, in Fig. 6, the broken line $L_2$ is similar to the broken line $L_2$ of the discharge curve shown in Fig. 5 and indicates an example of a discharge curve as the predetermined threshold value $V_{th}$ for sensing (determining) an abnormality of the DC capacitor 12.

Moreover, in Fig. 6, a dash-dotted line $L_3$ is illustrated. The dash-dotted line $L_3$ indicates an example of a discharge curve of the second predetermined threshold value $V_{th2}$ for sensing an indication of replacement (determining the time for replacement) of the DC capacitor 12. The dash-dotted line $L_3$ indicating the second predetermined threshold value $V_{th2}$ is smaller than the solid line $L_1$ indicating a reference value and larger than the broken line $L_2$ indicating the predetermined threshold value $V_{th}$ for sensing an abnormality of the DC capacitor 12.

When an abnormality such as a failure of the DC capacitor 12 or a case in which the capacitance of one DC capacitor 12 has been lost, for example, occurs, the DC capacitors 12 significantly drop in capacitance as compared with a case of degradation over time or the like. On the other hand, a drop in capacitance of the DC capacitors 12 is such that a drop in capacitance due to degradation over time, the lifetime, or the like is slower than a drop in capacitance due to capacitance loss, an abnormality, or the like of the DC capacitors 12 (the capacitance does not decrease significantly). Thus, the dash-dotted line $L_3$ indicating the second predetermined threshold value $V_{th2}$ shall be larger than the broken line $L_2$ indicating the predetermined threshold value $V_{th}$ for sensing an abnormality of the DC capacitor 12.

Then, in the modification of the first embodiment, the determination unit 33 determines that it is the time for replacement of the DC capacitor 12 when the DC voltage Vdc monitored by the monitoring unit 31 falls below the second predetermined threshold value $V_{th2}$ and exceeds the predetermined threshold value $V_{th}$. Then, when it is determined by the determination unit 33 that it is the time for replacement of the DC capacitor 12, the reporting unit 34 reports an indication that it is the time for replacement of the DC capacitor 12.

Note that also in the modification of the first embodiment, the determination unit 33 determines that the DC capacitor 12 has an abnormality when the DC voltage Vdc monitored by the monitoring unit 31 falls below the predetermined threshold value $V_{th}$ similarly to the first embodiment shown in Fig. 1 to Fig. 5. Then, when it is determined by the determination unit 33 that the DC capacitor 12 has an abnormality, the reporting unit 34 reports the abnormality of the DC capacitor 12.

Note that in the modification of the first embodiment, the second predetermined threshold value $V_{th2}$ may have (thereabove and therebelow or therebelow) a bandwidth or margin in a predetermined range (predetermined voltage value) similarly to the predetermined threshold value $V_{th}$. Then, the determination unit 33 may determine that it is the time for replacement of the DC capacitor 12 when the DC voltage Vdc falls below the second predetermined threshold value $V_{th2}$ by more than or equal to the predetermined range, rather than determining that it is the time for replacement of the DC capacitor 12 as soon as the DC voltage Vdc falls below the second predetermined threshold value $V_{th2}$.

Note that for the second predetermined threshold value $V_{th2}$, the bandwidth or margin in the predetermined range may also be varied depending on an estimated lifetime of the DC capacitor 12 or the like similarly to the predetermined threshold value $V_{th}$. In addition, the broken line $L_2$ indicating the predetermined threshold value $V_{th}$ and the dash-dotted line $L_3$ indicating the second predetermined threshold value $V_{th2}$ may be fixed by an experiment, a computation, a simulation, or the like and stored in the storage unit 40.

In addition, the broken line $L_2$ indicating the predetermined threshold value $V_{th}$ and the dash-dotted line $L_3$ indicating the second predetermined threshold value $V_{th2}$ may be expressed by making the bandwidth, margin, or the like different from a single threshold value (discharge curve). In other words, for a single threshold value (discharge curve), a first bandwidth may be set as the predetermined threshold value $V_{th}$, and a second bandwidth narrower than the first bandwidth may be set as the second predetermined threshold value $V_{th2}$.

In addition, the broken line $L_2$ indicating the predetermined threshold value $V_{th}$ and the dash-dotted line $L_3$ indicating the second predetermined threshold value $V_{th2}$ may be expressed by making the inclination of the discharge curve different. In other words, a discharge curve having a first inclination may be set as the predetermined threshold value $V_{th}$, and a discharge curve having a second inclination which is gentler than the first inclination may be set as the second predetermined threshold value $V_{th2}$.

Note that the remaining handling of the second predetermined threshold value $V_{th2}$, the determination operation performed by the determination unit 33, and the like are identical or similar to handling of the predetermined threshold value $V_{th}$, the determination operation performed by the determination unit 33, and the like in the first embodiment shown in Fig. 1 to Fig. 5. Thus, detailed description and illustration are omitted.

<OPERATIONAL EFFECTS OF MODIFICATION OF FIRST EMBODIMENT>

The above modification of the first embodiment shown in Fig. 6 exerts operational effects similar to those of the first embodiment shown in Fig. 1 to Fig. 5.

Moreover, in the modification of the first embodiment shown in Fig. 6, the second predetermined threshold value ($V_{th2} = L_3$) for determining the time for replacement of the DC capacitor 12 is used. Accordingly, according to the present embodiment, a user is allowed to know not only an abnormality of the DC capacitor 12, but also the time for replacement of the DC capacitor 12 on the basis of the discharge voltage of the DC voltage Vdc when the inverter device 10 stops.

<SECOND EMBODIMENT>

Fig. 7 is a diagram showing a configuration example of a power conversion apparatus 1A according to a second embodiment.

In the second embodiment, components which are identical or similar to those of the first embodiment and its modification shown in Fig. 1 to Fig. 6 are denoted by the same reference characters, and detailed description will be omitted or simplified.

In the second embodiment, an inverter device 10A of the power conversion apparatus 1A is a multilevel power converter in which two DC capacitors 12P and 12N are connected in series via a DC neutral point C. Note that although a three-level multilevel power converter in which the two DC capacitors 12P and 12N are connected in series via the DC neutral point C will be described with reference to Fig. 7 as an example of the inverter device 10A, the DC capacitors 12P and 12N may include a plurality of DC capacitors more than or equal to two. Note that a plurality of the discharge resistors 13 may also be provided depending on the DC capacitors 12P and 12N.

As shown in Fig. 7, in the inverter device 10A, the two (plurality of) DC capacitors 12P and 12N are connected in series via the DC neutral point C, and two semiconductor switching elements (neutral point elements) Q are connected in anti-series to the DC neutral point C in each of the three phases. Note that in the example shown in Fig. 7, the semiconductor switching elements (neutral point elements) Q are connected in anti-series to have the collector side of the IGBT in common, but may be connected in anti-series to have the emitter side in common.

Fig. 8 is a diagram showing a configuration example of a controller 30A in the power conversion apparatus 1A shown in Fig. 7. As shown in Fig. 8, the controller 30A in the second embodiment has a monitoring unit 31A instead of the monitoring unit 31 in the first embodiment and its modification shown in Fig. 1 to Fig. 6 and has a determination unit 33A instead of the determination unit 33.

The monitoring unit 31A always obtains and monitors information on a DC voltage Vdcp of the DC capacitor 12P and a DC voltage Vdcn of the DC capacitor 12N detected by the DC voltage sensor 22. Note that the monitoring unit 31A may obtain and monitor the information on the DC voltage Vdcp of the DC capacitor 12P and the DC voltage Vdcn of the DC capacitor 12N at a predetermined time interval, for example. Alternatively, the monitoring unit 31A may obtain and monitor the information on the DC voltage Vdcp of the DC capacitor 12P and the DC voltage Vdcn of the DC capacitor 12N in accordance with an instruction received from an operator or the like via a host device not shown or an operation unit not shown, for example. Alternatively, the monitoring unit 31A may obtain and monitor the information on the DC voltage Vdcp of the DC capacitor 12P and the DC voltage Vdcn of the DC capacitor 12N when the inverter device 10A stops.

The determination unit 33A obtains the information on the DC voltage Vdcp of the DC capacitor 12P and the DC voltage Vdcn of the DC capacitor 12N monitored by the monitoring unit 31A when it is timed by the timing unit 32 that the predetermined time period $t_1$ has elapsed since the inverter device 10A stops. Then, when it is timed by the timing unit 32 that the predetermined time period $t_1$ has elapsed since the inverter device 10 stops, the determination unit 33A compares the DC voltage Vdcp of the DC capacitor 12P and the DC voltage Vdcn of the DC capacitor 12N. In other words, the determination unit 33A compares DC voltage values of the plurality of DC capacitors 12P and 12N.

Note that the determination unit 33A may always obtain the information on the DC voltage Vdcp of the DC capacitor 12P and the DC voltage Vdcn of the DC capacitor 12N monitored by the monitoring unit 31A. Then, the determination unit 33A may always continue comparing the DC voltage Vdcp of the DC capacitor 12P and the DC voltage Vdcn of the DC capacitor 12N.

When the DC voltage Vdcp of the DC capacitor 12P and the DC voltage Vdcn of the DC capacitor 12N having been compared differ from each other by more than or equal to a predetermined threshold value $V_{th3}$, the determination unit 33A determines that either the DC capacitor 12P or 12N has an abnormality. Then, when determining that either the DC capacitor 12P or 12N has an abnormality, the determination unit 33A outputs information on the determination that either the DC capacitor 12P or 12N has an abnormality to the reporting unit 34. Note that when determining that the DC capacitor 12 has an abnormality, the determination unit 33A may output the information on the determination that either the DC capacitor 12P or 12N has an abnormality to an external device such as a host device not shown.

In other words, when an abnormality occurs in either the DC capacitor 12P or 12N, either one of them drops in capacitance. Thus, in case an abnormality occurs in either the DC capacitor 12P or 12N, when the DC voltage Vdcp of the DC capacitor 12P and the DC voltage Vdcn of the DC capacitor 12N are compared, their voltage values differ from each other by more than or equal to the predetermined threshold value $V_{th3}$. On the other hand, in case both the DC capacitor 12P and 12N are normal, when the DC voltage Vdcp of the DC capacitor 12P and the DC voltage Vdcn of the DC capacitor 12N are compared, their voltage values do not differ from each other by more than or equal to the predetermined threshold value $V_{th3}$. In the second embodiment, an abnormality of either the DC capacitor 12P or 12N is detected by such a principle.

Note that the predetermined threshold value $V_{th3}$ may vary depending on an operating situation of the inverter device 10A, or may be set in advance by an experiment, a simulation, or the like and stored in the storage unit 40, for example. Alternatively, the predetermined threshold value $V_{th3}$ may be set in accordance with an instruction received from a host device not shown, an instruction received from an operator not shown via an operation unit not shown, or the like, for example.

In addition, in the second embodiment, the predetermined threshold value $V_{th3}$ may have (thereabove and therebelow or therebelow) a bandwidth or margin in a predetermined range (predetermined voltage value) similarly to the predetermined threshold value $V_{th}$. Then, the determination unit 33A may determine that either the DC capacitor 12P or 12N has an abnormality when the DC voltages Vdc differ from each other by more than or equal to the predetermined range from the predetermined threshold value $V_{th3}$, rather than determining that either the DC capacitor 12P or 12N has an abnormality as soon as the DC voltages Vdc differ from each other by more than or equal to the predetermined threshold value $V_{th3}$. Note that also for the predetermined threshold value $V_{th3}$, the bandwidth or margin in the predetermined range may be varied depending on an estimated lifetime of the DC capacitor 12P or 12N or the like similarly to the predetermined threshold value $V_{th}$.

In addition, in the second embodiment, a second predetermined threshold value $V_{th4}$ for sensing an indication of the time for replacement (determining the time for replacement) of either the DC capacitor 12P or 12N may also be used similarly to the modification of the first embodiment shown in Fig. 6. In this case, the determination unit 33A compares the DC voltage Vdcp of the DC capacitor 12P and the DC voltage Vdcn of the DC capacitor 12N, and when they differ from each other by more than or equal to the second predetermined threshold value $V_{th4}$, determines that it is the time for replacement of either the DC capacitor 12P or 12N. Note that the second predetermined threshold value $V_{th4}$ is a value smaller than the predetermined threshold value $V_{th3}$.

Note that the second predetermined threshold value $V_{th4}$ may also have (thereabove and therebelow or therebelow) a bandwidth or margin in a predetermined range (predetermined voltage value) similarly to the predetermined threshold value $V_{th3}$. Note that also for the second predetermined threshold value $V_{th4}$, the bandwidth or margin in the predetermined range may be varied depending on an estimated lifetime of the DC capacitor 12 or the like similarly to the predetermined threshold value $V_{th}$.

Fig. 9 is a flowchart showing an example of operation of the controller 30A in the power conversion apparatus 1A shown in Fig. 7 and Fig. 8. The flowchart shown in Fig. 9 has steps S3A and S4A instead of steps S3 and S4 in the flowchart shown in Fig. 3.

In step S3A, the determination unit 33A obtains from the monitoring unit 31A information on the DC voltage Vdcp of the DC capacitor 12P and the DC voltage Vdcn of the DC capacitor 12N at the point of time when the predetermined time period $t_1$ elapses.

In step S4A, the determination unit 33A compares the DC voltage Vdcp of the DC capacitor 12P and the DC voltage Vdcn of the DC capacitor 12N at the point of time when the predetermined time period $t_1$ elapses. Then, the determination unit 33A determines whether or not the difference between the DC voltage Vdcp of the DC capacitor 12P and the DC voltage Vdcn of the DC capacitor 12N as compared falls within a range of the predetermined threshold value $V_{th3}$ (within a predetermined range from the predetermined threshold value $V_{th3}$).

Then, when determining that the difference between the DC voltage Vdcp of the DC capacitor 12P and the DC voltage Vdcn of the DC capacitor 12N as compared falls within the range of the predetermined threshold value $V_{th3}$ (Yes side), the determination unit 33A causes the process to transition to step S5.

On the other hand, when determining that the difference between the DC voltage Vdcp of the DC capacitor 12P and the DC voltage Vdcn of the DC capacitor 12N as compared does not fall within the range of the predetermined threshold value $V_{th3}$ (No side), the determination unit 33A causes the process to transition to step S6.

Note that the remaining configuration, operation, and the like of the second embodiment are identical or similar to the configurations, operations, and the like of the first embodiment and its modification shown in Fig. 1 to Fig. 6. Thus, detailed description and illustration are omitted.

<OPERATIONAL EFFECTS OF SECOND EMBODIMENT>

The above second embodiment shown in Fig. 7 to Fig. 9 exerts operational effects similar to those of the first embodiment and its modification shown in Fig. 1 to Fig. 6.

Moreover, the second embodiment shown in Fig. 7 to Fig. 9 enables a user to know an abnormality of, or the time for replacement of, either the DC capacitor 12P or 12N by comparing the DC voltage Vdcp of the DC capacitor 12P and the DC voltage Vdcn of the DC capacitor 12N. This enables the user to know an abnormality of, or the time for replacement of, either the DC capacitor 12P or 12N without using the predetermined threshold value $V_{th}$ or the second predetermined threshold value $V_{th2}$ based on discharge curves or the like during the factory acceptance test or design values in the multilevel power converter. Accordingly, according to the present embodiment, the user is allowed to know an abnormality of, or the time for replacement of, either the DC capacitor 12P or 12N by a simple method.

<HARDWARE CONFIGURATION EXAMPLE>

Fig. 10 is a conceptual diagram showing a hardware configuration example of a processing circuit 90 that the controller 30 or 30A in the embodiments shown in Fig. 1 to Fig. 9 has. The respective functions described above are implemented by the processing circuit 90. As a mode, the processing circuit 90 includes at least one processor 91 and at least one memory 92. As another mode, the processing circuit 90 includes at least one piece of dedicated hardware 93.

In the case in which the processing circuit 90 includes the processor 91 and the memory 92, the respective functions are implemented by software, firmware, or a combination of software and firmware. At least one of the software and firmware is written as a program. At least one of the software and firmware is stored in the memory 92. The processor 91 reads out and executes the program stored in the memory 92, thereby implementing the respective functions.

In the case in which the processing circuit 90 includes the dedicated hardware 93, the processing circuit 90 is a single circuit, a composite circuit, a programmed processor, or a combination of them, for example. The respective functions are implemented by the processing circuit 90.

Each of the respective functions that the controller 30 or 30A has may be configured by hardware partly or entirely, or may be configured as a program to be executed by the processor. In other words, the controller 30 or 30A can be implemented by a computer and a program, and the program can also be stored in a storage medium or can be provided through a network.

<SUPPLEMENTARY NOTES OF EMBODIMENTS>

The above embodiments shown in Fig. 1 to Fig. 10 are divided into the first embodiment and its modification shown in Fig. 1 to Fig. 6 and the second embodiment shown in Fig. 7 to Fig. 9. However, some or all of these embodiments may be combined in series or in parallel. A combined embodiment can also exert operational effects similar to the respective operational effects exerted by the respective embodiments before being combined.

In addition, the embodiments shown in Fig. 1 to Fig. 10 have been described taking the power conversion apparatus 1 and 1A as well as the controllers 30 and 30A that they have as examples as a mode of the present disclosure, the present disclosure is not limited to this. The present disclosure can also be implemented as a control method by which the processing steps in the respective units of the controller 30 or 30A are to be performed.

In addition, the present disclosure can also be implemented as a control program that causes a computer to execute the processing steps in the respective units of the controller 30 or 30A.

In addition, the present disclosure can also be implemented as a storage medium (non-transitory computer-readable storage medium) in which a control program is stored. The control program can be stored in a removable medium such as, for example, a CD (Compact Disc), a DVD (Digital Versatile Disc), or a USB (Universal Serial Bus) memory for distribution. Note that the control program may be uploaded onto a network via a network interface or the like not shown that the controller 30 or 30A has, and may be downloaded from the network and stored in the storage unit 40, the memory 92, or the like.

From the above detailed description, features and advantages of the embodiments will become apparent. This is intended that claims involve the features and advantages of the embodiments as described above within a range not departing from the spirit and scope thereof. In addition, a person with an ordinary skill in the technical field should be able to reach all improvements and modifications. Therefore, it is not intended to limit the scope of the inventive embodiments to the foregoing, and it can depend on appropriate improvements and equivalents involved in the scope disclosed in the embodiments.

Reference Signs List

1, 1A...Power conversion apparatus; 10, 10A...Inverter device (device); 11...DC Input section; 11N... Negative electrode terminal; 11P... Positive electrode terminal; 12, 12P, 12N...DC capacitor; 13...Discharge resistor; 14...Inverter circuit; 15...AC output section; 15U...U-phase terminal; 15V...V-phase terminal; 15W...W-phase terminal; 21...DC current sensor; 22...DC voltage sensor; 23...AC current sensor; 24... AC voltage sensor; 30, 30A...Controller; 31, 31A... Monitoring unit; 32...Timing unit; 33, 33A...Determination unit; 34... Reporting unit; 35...PWM control unit; 40...Storage unit; 90...Processing circuit; 91...Processor; 92... Memory; 93...Hardware; C...DC neutral point; D...Freewheeling diode; Iac...AC current; Idc...DC current; $L_1$...Solid line; $L_2$...Broken line; $L_3$...Dash-dotted line; Q...Semiconductor switching element; $t_0$, $t_1$...Time period; Vac... AC voltage (AC voltage value); Vdc, Vden, Vdcp...DC voltage (DC voltage value); $V_{th}$...Predetermined threshold value; $V_{th2}$...Second predetermined threshold value; $V_{th3}$...Predetermined threshold value; $V_{th4}$...Second predetermined threshold value

**Claims**

1. A power conversion apparatus comprising:

   an inverter device that comprises:

   a DC input section having a positive electrode terminal and a negative electrode terminal;
   an inverter circuit that converts power on a basis of a switching operation of a switching element;
   a DC capacitor that absorbs and smooths a ripple current generated by the switching operation of the inverter circuit between the positive electrode terminal and the negative electrode terminal;
   a discharge resistor in which charges of the DC capacitor are discharged; and
   a DC voltage sensor that detects a DC voltage value of the DC capacitor; and

   a controller that comprises:

   a monitoring unit that monitors the DC voltage value detected by the DC voltage sensor;
   a timing unit that times an elapsed time period since the inverter device stops;
   a determination unit that when it is timed by the timing unit that a predetermined time period has elapsed since the inverter device stops, determines that the DC capacitor has an abnormality when the DC voltage value being monitored by the monitoring unit falls below a predetermined threshold value which is a value smaller than a normal value by more than or equal to a predetermined range; and
   a reporting unit that when it is determined by the determination unit that the DC capacitor has the abnormality, reports the abnormality of the DC capacitor.

2. The power conversion apparatus according to claim 1, wherein

   the predetermined threshold value is set on a basis of a discharge curve indicating a transition of the DC voltage value when the DC capacitor discharges after the inverter device stops,
   the discharge curve is gained on a basis of an actual measurement value of the transition of the DC voltage value after the inverter device stops during a factory acceptance test for the power conversion apparatus, and
   when it is timed by the timing unit that the predetermined time period has elapsed since the inverter device stops, the determination unit determines that the DC capacitor has the abnormality when the DC voltage value being monitored by the monitoring unit falls below the predetermined threshold value set on the basis of the discharge curve by more than or equal to the predetermined range.

**3.** The power conversion apparatus according to claim 1, wherein

the predetermined threshold value is set on a basis of a discharge curve (v(t)) indicating a transition of the DC voltage value when the DC capacitor discharges after the inverter device stops,

the discharge curve (v(t)) is gained by substituting a design value (C) of a capacitance of the DC capacitor, a design value (R) of a resistance value of the discharge resistor, a DC voltage value (Vdc) when the inverter device stops, and an elapsed time period (t) since the inverter device stops into Expression (1) below:

[Math. 1]

$$v(t) = Vdc \times e^{\frac{-t}{CR}} \qquad \cdots \quad (1)$$

when it is timed by the timing unit that the predetermined time period ($t_1$) has elapsed since the inverter device stops, the determination unit gains a DC voltage value ($v(t_1)$) when the predetermined time period ($t_1$) is substituted into the Expression (1), and when it is timed by the timing unit that the predetermined time period ($t_1$) has elapsed since the inverter device stops, the determination unit determines that the DC capacitor has the abnormality when the DC voltage value being monitored by the monitoring unit falls below the predetermined threshold value set on a basis of the DC voltage value ($v(t_1)$) as gained by more than or equal to the predetermined range.

**4.** The power conversion apparatus according to claim 1, wherein

when it is timed by the timing unit that the predetermined time period has elapsed since the inverter device stops, the determination unit determines that it is a time for replacement of the DC capacitor when the DC voltage value being monitored by the monitoring unit falls below a second predetermined threshold value which is smaller than the normal value and larger than the predetermined threshold value by more than or equal to the predetermined range and exceeds the predetermined threshold value, and

when it is determined by the determination unit that it is the time for replacement of the DC capacitor, an indication of the time for replacement of the DC capacitor is reported.

**5.** A power conversion apparatus comprising:

an inverter device that comprises:

a DC input section having a positive electrode terminal and a negative electrode terminal;
an inverter circuit that converts power on a basis of a switching operation of a switching element;
a plurality of DC capacitors that are connected in series via a DC neutral point between the positive electrode terminal and the negative electrode terminal, and absorb and smooth a ripple current generated by the switching operation of the inverter circuit,
a discharge resistor in which charges of the plurality of DC capacitors are discharged respectively; and
a DC voltage sensor that detects each of DC voltage values of the plurality of DC capacitors, and

a controller that comprises:

a monitoring unit that monitors each of the DC voltage values of the plurality of DC capacitors detected by the DC voltage sensor;
a timing unit that times an elapsed time period since the inverter device stops;
a determination unit that when it is timed by the timing unit that a predetermined time period has elapsed since the inverter device stops, compares the DC voltage values of the plurality of DC capacitors being monitored by the monitoring unit, and when the DC voltage values of the plurality of DC capacitors as compared differ from each other by more than or equal to a predetermined threshold value, determines that any DC capacitor among the plurality of DC capacitors as compared has an abnormality; and
a reporting unit that when it is determined by the determination unit that any DC capacitor among the plurality of DC capacitors has the abnormality, reports that any DC capacitor among the plurality of DC capacitors has the abnormality.

**6.** A controller of a power conversion apparatus including an inverter device having

a DC input section having a positive electrode terminal and a negative electrode terminal,
an inverter circuit that converts power on a basis of a switching operation of a switching element,
a DC capacitor that absorbs and smooths a ripple current generated by the switching operation of the inverter circuit between the positive electrode terminal and the negative electrode terminal,

a discharge resistor in which charges of the DC capacitor are discharged, and

a DC voltage sensor that detects a DC voltage value of the DC capacitor,

the controller comprising:

a monitoring unit that monitors the DC voltage value detected by the DC voltage sensor;

a timing unit that times an elapsed time period since the inverter device stops;

a determination unit that when it is timed by the timing unit that a predetermined time period has elapsed since the inverter device stops, determines that the DC capacitor has an abnormality when the DC voltage value being monitored by the monitoring unit falls below a predetermined threshold value which is a value smaller than a normal value by more than or equal to a predetermined range; and

a reporting unit that when it is determined by the determination unit that the DC capacitor has the abnormality, reports the abnormality of the DC capacitor.

# FIG.1

DC CAPACITOR
12

11P

P

11

DISCHARGE
RESISTOR
13

N

11N

21

22

DETECT AND MONITOR
DC VOLTAGE Vdc
AND

DC CURRENT Idc

GATE SIGNAL

14

Q   D   Q   D   Q   D

Q   D   Q   D   Q   D

1

10

15U

15

15V

15W

23   24

DETECT, MONITOR,
AND CONTROL
AC VOLTAGE Vac
AND

AC CURRENT Iac

CONTROLLER                     30

EXAMPLE OF POWER CONVERSION APPARATUS

# FIG.2

30

CONTROLLER

31 — MONITORING UNIT

32 — TIMING UNIT

33 — DETERMINATION UNIT

34 — REPORTING UNIT

35 — PWM CONTROL UNIT

40 — STORAGE UNIT

# FIG.3

```
        ┌──────────┐
        │  START   │
        └────┬─────┘
             │
        ┌────▼─────────┐
        │ START TIMING │ ～S1
        └────┬─────────┘
             │
        ┌────▼─────────┐
        │ HAS t1 ELAPSED? │ ～S2 ──NO──┐
        └────┬─────────┘              │
           YES│                       │
        ┌────▼─────────┐              │
        │ OBTAIN Vdc, Vth │ ～S3       │
        └────┬─────────┘              │
             │                        │
   ┌─────────▼──────────┐             │
   │ DOES Vdc FALL       │ ～S4        │
   │ WITHIN              │──NO──┐      │
   │ PREDETERMINED RANGE │      │      │
   │ FROM Vth?           │      │      │
   └─────────┬──────────┘      │      │
          YES│ ～S5          ～S6│      │
   ┌─────────▼──────┐   ┌───────▼────┐ │
   │   CONTINUE     │   │  REPORT    │ │
   │  DISCHARGING   │   │ ABNORMALITY│ │
   └─────────┬──────┘   └───────┬────┘ │
             │◄─────────────────┘      │
        ┌────▼─────┐                   │
        │   END    │                   │
        └──────────┘                   │
```

DETECTION FLOW

# FIG.4

CAPACITOR
VOLTAGE
(V)

DEVICE STOPS

Vdc:DC VOLTAGE
C:CAPACITOR CAPACITANCE
R:RESISTANCE VALUE
  OF DISCHARGE RESISTOR

Vdc

$L_1$

$v(t) = Vdc \times e^{\frac{-t}{CR}}$

$v(t_1)$

$t_0$  $t_1$

TIME (t)

DISCHARGING OF CAPACITOR AFTER DEVICE STOPS

# FIG.5

CAPACITOR VOLTAGE (V)

DEVICE STOPS

Vdc:DC VOLTAGE
C:CAPACITOR CAPACITANCE
R:RESISTANCE VALUE
  OF DISCHARGE RESISTOR

Vdc

L1

$$v(t)=Vdc \times e^{\frac{-t}{CR}}$$

L2

v(t1)

Vth

DISCHARGING BECOMES SOONER
(VOLTAGE DROPS SOONER)
WHEN CAPACITOR CAPACITANCE DECREASES
DUE TO ABNORMALITY/DEGRADATION

t0  t1

TIME (t)

DISCHARGING OF CAPACITOR AFTER DEVICE STOPS

# FIG.6

CAPACITOR
VOLTAGE
(V)

L1

L3

L2

TIME (t)

———:REFERENCE VALUE
(VALUE ACTUALLY MEASURED IN FACTORY OR
VALUE BASED ON DESIGN VALUE)

·-----:VALUE FOR SENSING ABNORMALITY OF CAPACITOR
(PREDETERMINED THRESHOLD VALUE Vth)

—·—:VALUE FOR DETERMINING INDICATION OF
REPLACEMENT OF CAPACITOR
(SECOND PREDETERMINED THRESHOLD VALUE Vth2)
WHICH SHALL BE LARGER THAN VALUE FOR SENSING
ABNORMALITY

# FIG.7

EXAMPLE OF POWER CONVERSION APPARATUS

# FIG.8

30A

CONTROLLER

31A — MONITORING UNIT

32 — TIMING UNIT

33A — DETERMINATION UNIT

34 — REPORTING UNIT

35 — PWM CONTROL UNIT

40 — STORAGE UNIT

# FIG.9

```
        ┌──────────────┐
        │    START     │
        └──────────────┘
               │
               ▼
        ┌──────────────┐
        │ START TIMING │──── S1
        └──────────────┘
               │
               ▼
          ◇──────────◇         S2
         ╱            ╲
        ◇ HAS t1 ELAPSED? ◇─────────┐ NO
         ╲            ╱              │
          ◇──────────◇              │
               │ YES                │
               ▼                    │
        ┌──────────────┐            │
        │OBTAIN Vdcp, Vdcn│──── S3A  │
        └──────────────┘            │
               │                    │
               ▼                    │
          ◇──────────◇         S4A   │
         ╱  DOES DIFFERENCE ╲       │
        ◇ BETWEEN Vdcp AND Vdcn◇─── NO
         ╲ FALL WITHIN RANGE ╱      │
          ◇   OF Vth3?   ◇          │
               │ YES                ▼
               ▼  S5         ┌──────────────┐
        ┌──────────────┐     │    REPORT    │──── S6
        │   CONTINUE   │     │  ABNORMALITY │
        │ DISCHARGING  │     └──────────────┘
        └──────────────┘            │
               │◄───────────────────┘
               ▼
        ┌──────────────┐
        │     END      │
        └──────────────┘
```

DETECTION FLOW

FIG.10

## INTERNATIONAL SEARCH REPORT

International application No.

**PCT/JP2023/032118**

| | |
|---|---|
| **A. CLASSIFICATION OF SUBJECT MATTER** | |

*H02M 7/48*(2007.01)i

FI: H02M7/48 M

According to International Patent Classification (IPC) or to both national classification and IPC

**B. FIELDS SEARCHED**

Minimum documentation searched (classification system followed by classification symbols)

H02M7/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2020-111441 A (TOSHIBA ELEVATOR AND BUILDING SYSTEMS CORPORATION) 27 July 2020 (2020-07-27) paragraphs [0031]-[0049], fig. 5-7 | 1-6 |
| A | JP 2008-043061 A (OMRON CORPORATION) 21 February 2008 (2008-02-21) entire text, all drawings | 1-6 |
| A | JP 8-80055 A (TOSHIBA CORPORATION) 22 March 1996 (1996-03-22) entire text, all drawings | 1-6 |

☐ Further documents are listed in the continuation of Box C.　　☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **12 October 2023** | **31 October 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/032118**

| Patent document cited in search report | | | Publication date (day/month/year) | Patent family member(s) | | | Publication date (day/month/year) |
|---|---|---|---|---|---|---|---|
| JP | 2020-111441 | A | 27 July 2020 | JP | 6690842 | B1 | |
| JP | 2008-043061 | A | 21 February 2008 | (Family: none) | | | |
| JP | 8-80055 | A | 22 March 1996 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008228370 A